# FASCICULE DE BREVET EUROPEEN

(11) **EP 2 836 999 B1**
(45) Date de publication et mention de la délivrance du brevet: **10.07.2019**
(21) Numéro de dépôt: 13717472.8
(22) Date de dépôt: 10.04.2013
(51) Int. Cl.: G11C 13/00, H01L 45/00

(54) **UTILISATION D'ISOLANTS DE MOTT CENTROSYMÉTRIQUES DANS UNE MÉMOIRE DE STOCKAGE DE DONNÉES À COMMUTATION RÉSISTIVE**
VERWENDUNG VON ZENTROSYMMETRISCHEN MOTT-ISOLATOREN IN EINEM RESISTIV GESCHALTETEN SPEICHER ZUR SPEICHERUNG VON DATEN
USE OF CENTROSYMMETRIC MOTT INSULATORS IN A RESISTIVELY SWITCHED MEMORY FOR STORING DATA

(30) Priorité: 10.04.2012 FR 1253275
(43) Date de publication de la demande: 18.02.2015
(73) Titulaire: Centre National de la Recherche Scientifique (C.N.R.S.), 75794 Paris Cedex 16 (FR); Université de Nantes, 44035 Nantes Cedex 1 (FR)
(72) Inventeur: CARIO, Laurent, F-44200 Nantes (FR); JANOD, Etienne, F-44240 La Chapelle sur Erdre (FR); CORRAZE, Benoit, F-44470 Carquefou (FR); BESLAND, Marie-Paule, F-44700 Orvault (FR); GUIOT, Vincent, F-44300 Nantes (FR)
(74) Mandataire: Lavoix
(86) Numéro de dépôt international: PCT/EP2013/057500
(87) Numéro de publication internationale: WO 2013/153120

(56) Documents cités:
- US-A1- 2009 231 083
- V. GUIOT ET AL: "Control of the Electronic Properties and Resistive Switching in the New Series of Mott Insulators GaTa 4 Se 8- y Te y (0 <= y <= 6.5)", CHEMISTRY OF MATERIALS, vol. 23, no. 10, 24 mai 2011 (2011-05-24), pages 2611-2618, XP055042641, ISSN: 0897-4756, DOI: 10.1021/cm200266n
- SOUCHIER E ET AL: "Resistive Switching Driven by Electric Field in the Mott Insulators AM4X8 (A = Ga, Ge; M= V, Nb, Ta; X = S, Se): Towards a New Class of Non-Volatile RRAM Memory", MEMORY WORKSHOP (IMW), 2011 3RD IEEE INTERNATIONAL, IEEE, 22 mai 2011 (2011-05-22), pages 1-4, XP031947206, DOI: 10.1109/IMW.2011.5873220 ISBN: 978-1-4577-0225-9
- LAURENT CARIO ET AL: "Electric-Field-Induced Resistive Switching in a Family of Mott Insulators: Towards a New Class of RRAM Memories", ADVANCED MATERIALS, vol. 22, no. 45, 18 octobre 2010 (2010-10-18), pages 5193-5197, XP055042723, ISSN: 0935-9648, DOI: 10.1002/adma.201002521

## Description

### 1. DOMAINE DE L'INVENTION

Le domaine de l'invention est celui des mémoires de stockage de données.

Plus précisément, l'invention concerne un composé formant le matériau actif d'une mémoire à commutation résistive, en particulier pour le stockage électronique de données.

L'invention peut s'appliquer notamment, mais non exclusivement, aux mémoires non-volatiles de type RRAM (pour « Resistive Random Access Memory » en anglais) et aux MEMRISTORS.

### 2. ARRIÈRE-PLAN TECHNOLOGIQUE

La technologie actuelle des mémoires non-volatiles est dominée par les mémoires Flash qui sont utilisées dans de nombreuses applications grand public (comme par exemple les appareils photo numériques, les clés USB, etc.). Ce sont des mémoires à semi-conducteurs réinscriptibles.

Ces mémoires Flash sont cependant confrontées à un certain nombre d'obstacles quant à leur développement technologique. Leur tenue en cyclage est limitée, les temps d'écriture et d'effacement sont relativement élevés (supérieurs à 10 *µ*s et 1 ms, respectivement) et de fortes tensions sont nécessaires pour réaliser le stockage de données (supérieures à 10 V). Par ailleurs, cette technologie arrive à ses limites en termes de réduction de taille.

Récemment, les mémoires RRAM et les MEMRISTORS sont apparues comme des solutions alternatives aux mémoires Flash. En effet, dans les mémoires RRAM et dans les MEMRISTORS, des impulsions électriques très courtes, généralement de l'ordre de 100 ns, génèrent une variation de la résistance électrique d'un simple dispositif constitué de deux électrodes séparées par un matériau actif.

On entend par « matériau actif », dans la suite de la description, un matériau susceptible de présenter au moins deux états de résistance électrique distincts, par application d'impulsions électriques.

On connaît, dans l'état de la technique, différents types de matériaux actifs intégrés dans les mémoires RRAM ou dans les MEMRISTORS tels que par exemple : NiO, TiO₂, SrTiO₃.

Or de telles mémoires sont à ce jour encore en cours d'expérimentation, les phénomènes physicochimiques sous-jacents étant encore mal compris, et donc mal maîtrisés. L'application industrielle de telles mémoires pose donc de réelles difficultés. En particulier, ces mémoires ne répondent pas totalement aux exigences fixées par l'ITRS (« International Technology Roadmap for Semiconductors »), notamment en matière de tension de commutation, de température, de fenêtre mémoire, de durée de vie et d'intégration.

Le document US 20009/0231083 A1 de l'art antérieur fait référence a des matériaux fortement corrélés et dopés n ou p présentant une phase métallique comme matériaux actifs d'une mémoire de stockage de données à commutation résistive.

Le document XP55042641, Guiot et al.: "Control of the Electronic Properties and Resistive Switching in the New Series of Mott Insulators GaTa4Se8-yTey(0 ≤ y ≤ 6.5)",Chem. Mater. 2011, 23, 2611-2618, traite des composés de la famille des isolants de Mott du type AM₄X₈ non-centrosymétriques ne possédant donc pas de centre d'inversion.

### 3. OBJECTIFS DE L'INVENTION

L'invention, dans au moins un mode de réalisation, a notamment pour objectif de pallier ces différents inconvénients de l'état de la technique.

Plus précisément, dans au moins un mode de réalisation de l'invention, un objectif est de proposer un matériau utilisable comme matériau actif d'une mémoire de stockage de données à commutation résistive, présentant de réelles perspectives d'exploitation industrielle.

Au moins un mode de réalisation de l'invention a également pour objectif de proposer un matériau qui permette de commuter entre au moins deux états de résistance électrique par application de champs électriques de relativement faible amplitude.

Au moins un autre mode de réalisation de l'invention a également pour objectif de proposer un matériau qui permette d'obtenir des temps de commutation entre au moins deux états de résistance électrique inférieurs à ceux des mémoires de l'état de la technique discutées plus haut.

Dans un autre mode de réalisation, l'invention a pour objectif de proposer un tel matériau qui permette d'augmenter la quantité de données stockée par unité de volume.

### 4. EXPOSÉ DE L'INVENTION

Ces objectifs, ainsi que d'autres qui apparaîtront par la suite, sont atteints grâce à l'invention qui concerne l'utilisation d'un matériau selon la revendication 1.

Dans le cadre d'expérimentations réalisées sur des composés présentant des non-linéarités courant-tension, les inventeurs ont en effet découvert de façon surprenante l'existence d'un phénomène de commutation résistive induite par impulsion électrique dans la famille des isolants de Mott centrosymétriques. L'application successive d'impulsions électriques permet en effet de faire varier, de manière volatile ou non-volatile, la résistance de ces matériaux entre au moins deux états de résistance distincts, et ce de façon réversible.

Les Isolant de Mott constituent une classe de matériaux dont la structure électronique résulte de la présence de fortes répulsions électrostatiques entre électrons (on parle aussi de matériaux à forte corrélation électronique). La structure électronique particulière de cette famille de matériaux est plus longuement décrite dans la suite de ce document en relation avec les figures 1 à 3. Il est bien connu des connaissances générales de l'Homme du Métier que ces matériaux possèdent une bande d'énergie interdite au niveau de Fermi.

Parmi les isolants de Mott, on distingue ceux dont la structure cristallographique possède un centre d'inversion, et qui sont dits centrosymétriques, et ceux qui ne possèdent pas de centre d'inversion, et qui sont dits non-centrosymétriques.

Le comportement de commutation résistive (aussi appelé transition résistive), dont l'observation était inattendue à l'origine des travaux de recherche pour cette classe particulière d'isolants de Mott centrosymétriques, résulte d'une modification locale de la structure électronique de ces matériaux due à l'effet du champ électrique appliqué sur ceux-ci. En effet, l'effet du champ électrique sur ces matériaux permet de créer un claquage diélectrique par effet d'avalanche électronique qui a pour conséquence de détruire localement l'état isolant de Mott et de restaurer un état métallique.

De manière générale, on entend ici par « avalanche électronique » un phénomène électronique apparaissant sous la forme d'une augmentation du nombre de paires électron-trou au sein du matériau considéré. Ce phénomène d'avalanche électronique, bien connu dans les matériaux isolants de bandes et semi-conducteurs classiques centrosymétriques, mais jusque là inconnu dans les isolants de Mott, apparait sous la forme d'un changement brutal de l'état de résistance électrique du matériau soumis à un champ électrique de valeur prédéterminée.

Le matériau étant placé entre deux électrodes électriques, une telle structure permet de constituer un élément logique, et plus précisément une cellule élémentaire de stockage, pouvant prendre au moins deux états, un état de haute résistance électrique, un état de basse résistance électrique et éventuellement des états de résistance intermédiaires, ceci conduisant à la possibilité d'inscrire dans le matériau au moins deux états logiques. De plus, la simplicité d'une telle structure contribue à augmenter la quantité d'informations stockée par unité de volume, par comparaison aux structures plus complexes des mémoires Flash de l'état de la technique. Enfin, les inventeurs ont démontré, comme on le verra par la suite, qu'il est possible de générer, à température ambiante, des cycles de commutation entre deux états résistifs de manière reproductible, sans dégradation du matériau, et ceci peut être utilisé pour réaliser une mémoire réinscriptible.

Les caractéristiques courant/tension observées pour les isolants de Mott dans le cadre de l'invention permettent d'envisager des applications industrielles de l'utilisation de ces matériaux comme matériau actif dans des mémoires réinscriptibles de type RRAM ou MEMRISTORS par exemple.

Selon un premier mode de réalisation avantageux, le matériau appartient à une sous-famille de composés inorganiques.

De manière particulièrement avantageuse, le matériau appartient à une sous-famille de composés inorganiques répondant à la formulation NiS₂₋ₓSeₓ, avec 0 ≤ x ≤ 1.

De manière particulièrement avantageuse, le matériau appartient à une sous-famille de composés inorganiques répondant à la formulation V₂₋ₓMₓO₃, avec 0 ≤ x ≤ 1, M comprenant l'un au moins des éléments suivants : Ti, Cr, Fe, Al ou Ga. A noter que M peut être une combinaison des ces éléments.

Selon un deuxième mode de réalisation avantageux, le matériau appartient à une sous-famille de composés organiques.

Selon une approche avantageuse de l'invention, la composition chimique du matériau utilisé est choisie de façon à fixer une valeur seuil de champ électrique au delà de laquelle le matériau commute depuis un premier état de résistance électrique vers un ou plusieurs états de résistance électrique différents pour former une cellule élémentaire d'information contenant au moins deux états logiques.

Ainsi, il est possible d'ajuster la valeur seuil du champ électrique permettant de provoquer la commutation du matériau en fonction de l'ingénierie chimique du composé utilisé en tant que matériau actif. Selon une caractéristique avantageuse, la composition chimique du composé est choisie de façon à ce que la valeur seuil du champ électrique soit relativement basse, par exemple inférieure à 10 kV/cm et préférentiellement inférieure à 2 kV/cm.

### 5. LISTE DES FIGURES

D'autres caractéristiques et avantages de l'invention apparaîtront à la lecture de la description suivante, donnée à titre d'exemple indicatif et non limitatif, et des dessins annexés, dans lesquels :
- les figures 1 et 2 présentent un schéma de la structure électronique d'un métal et d'un semi-conducteur tel qu'obtenus dans le cadre de la théorie des bandes ;
- les figures 3a et 3b présentent un schéma de la structure électronique prenant en compte les répulsions coulombiennes pour deux types d'isolants de Mott, isolants de Mott-Hubbard d'une part (figure 3a) et isolants à transfert de charge d'autre part (figure 3b) ;
- les figures 3c et 3d présentent un schéma de la structure électronique des isolants de Mott dopés n (figure 3c) ou p (figure 3d), aussi appelés métaux corrélés ;
- la figure 4 illustre un schéma de la structure d'un composant logique de type Métal - Isolant de Mott - Métal intégrant un matériau actif selon l'invention ;
- la figure 5 représente un schéma de montage électrique expérimental utilisé dans le cadre de la figure 4 pour l'application d'impulsions de tension et l'observation des non-linéarités courant-tension du matériau actif ;
- les figures 6a à 6h représentent un ensemble de courbes expérimentales obtenues avec un premier exemple de matériau actif intégrant le montage de la figure 5 et répondant à la formule NiS₂₋ₓSeₓ:

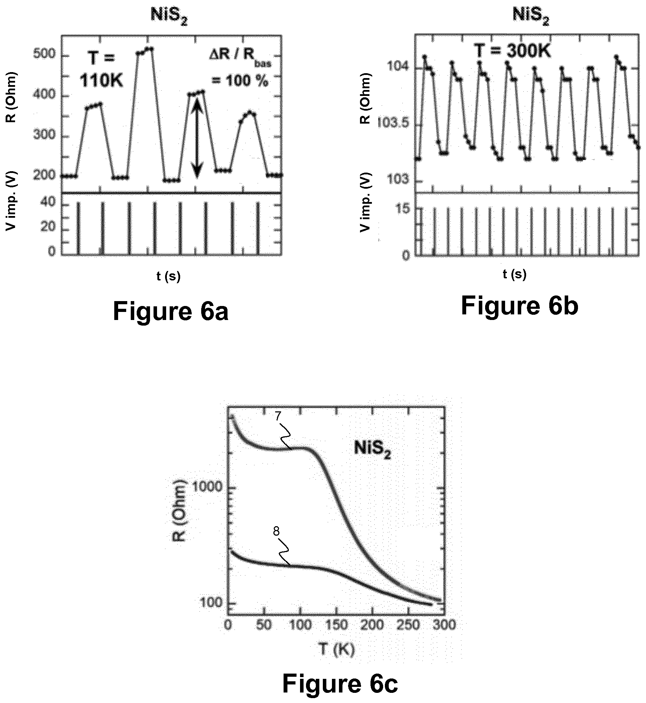

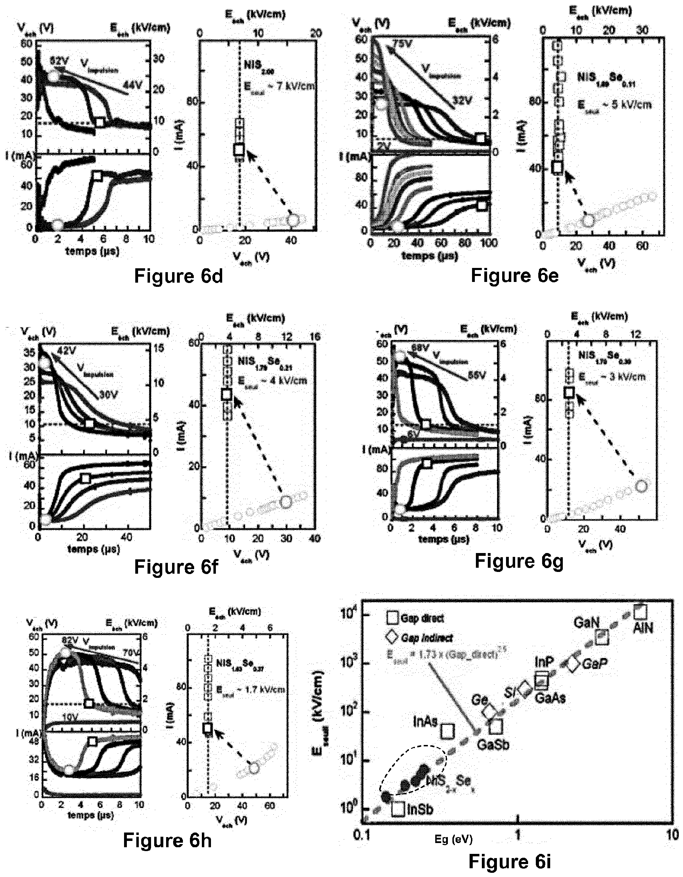

   * les figures 6a et 6b illustrent graphiquement le phénomène de commutation résistive non-volatile et réversible induite par impulsions de tension, obtenu pour le composé NiS₂ à 110K et à 300K respectivement ;
   * la figure 6c représente l'évolution de la résistance du composé NiS₂ en fonction de la température avant et après commutation de l'échantillon ;
   * les figures 6d à 6h représentent l'évolution temporelle de la tension et du courant mesurées aux bornes des composés NiS₂, NiS_{1.89}Se_{0.11}, NiS_{1.79}Se_{0.21}, NiS_{1.70}Se_{0.30}, NiS_{1.63}Se_{0.37}, ainsi que les caractéristiques courant-tension correspondantes ;
   * la figure 6i illustre l'évolution du champ seuil électrique provoquant une commutation résistive pour les composés illustrés aux figures 6d à 6h en fonction de l'énergie de bande interdite ;

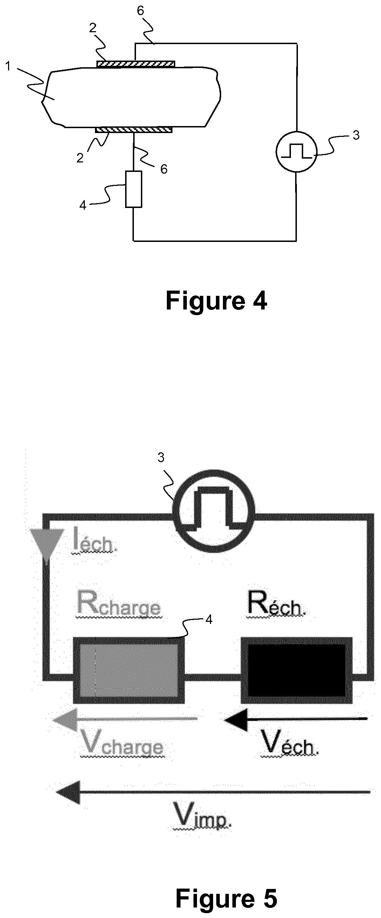

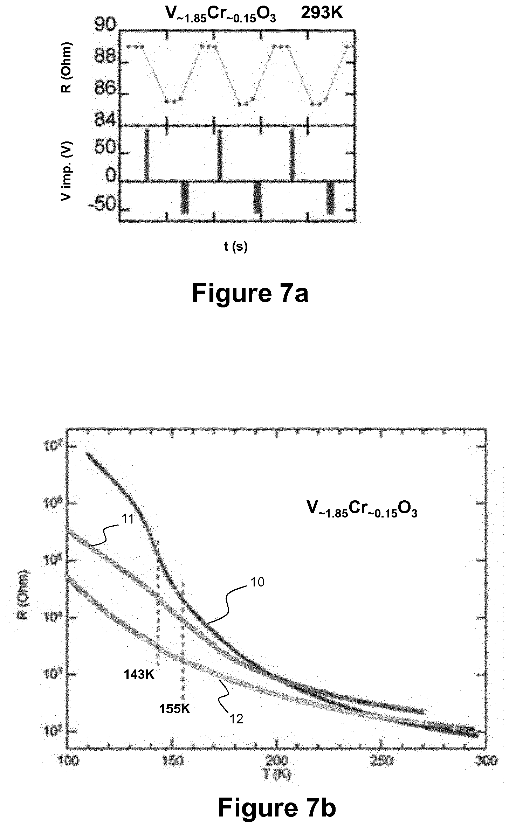

- les figures 7a à 7e représentent un ensemble de courbes expérimentales obtenues avec un deuxième exemple de matériau actif intégrant le montage de la figure 5 et répondant à la formule V₂₋ₓCrₓO₃ :
   * la figure 7a illustre graphiquement le phénomène de commutation résistive non-volatile et réversible induite par impulsions de tension obtenu pour le composé V_{∼1.85}Cr_{∼0.15}O₃ à 293K ;
   * la figure 7b représente l'évolution de la résistance du composé V_{∼1.85}Cr_{∼0.15}O₃ en fonction de la température avant et après commutations de l'échantillon ;

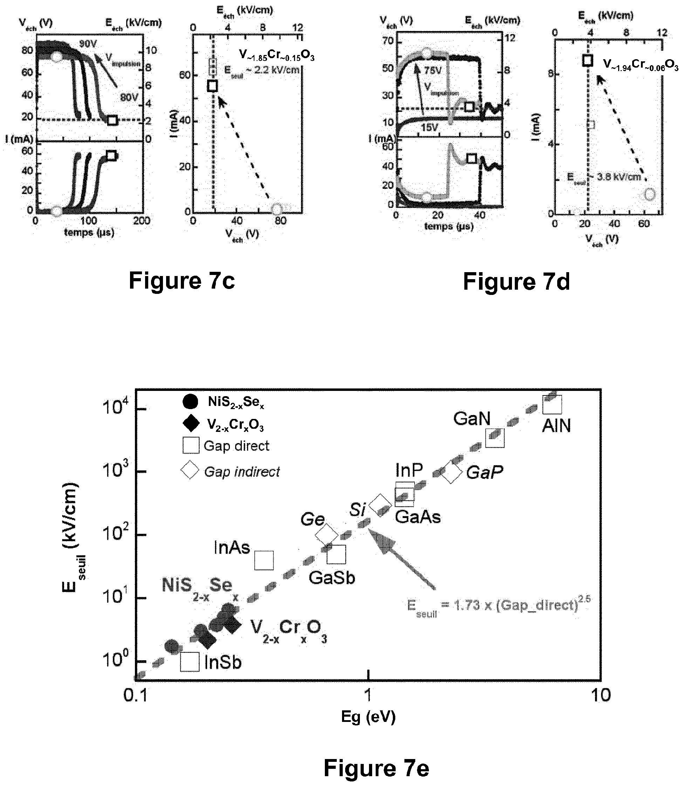

   * les figures 7c et 7d représentent l'évolution temporelle de la tension et du courant mesurés aux bornes des composés V_{∼1.85}Cr_{∼0.15}O₃ à 155 K (dans l'état isolant de Mott paramagnétique) et V_{∼1.94}Cr_{∼0.06}O₃ à 145 K (dans l'état isolant de Mott antiferromagnétique) ainsi que les caractéristiques courant-tension correspondantes ;
   * la figure 7e illustre l'évolution du champ électrique seuil provoquant une commutation résistive pour les composés illustrés aux figures 7c à 7d en fonction de l'énergie de bande interdite.

### 6. DESCRIPTION DÉTAILLÉE

Sur toutes les figures du présent document, les éléments et étapes identiques sont désignés par une même référence numérique.

Comme discuté précédemment, le principe de l'invention réside dans l'utilisation astucieuse d'un matériau appartenant à la famille des isolants de Mott centrosymétriques comme matériau actif dans une mémoire de stockage de données. Les inventeurs ont en effet mis en évidence l'existence, dans cette famille de matériaux, d'un phénomène de commutation résistive réversible induite par impulsion électrique. En particulier, les inventeurs ont découvert de façon surprenante que ce phénomène est intimement lié aux propriétés électroniques particulières de ces matériaux. En effet, lorsqu'un champ électrique d'une valeur prédéterminée est appliqué sur l'un des ces matériaux, la structure électronique dudit matériau s'en trouve modifiée : les travaux de recherche menés ces dernières années montrent que la commutation résistive est initiée par un phénomène d'origine électronique comparable au phénomène d'avalanche électronique connu dans les semi-conducteurs, mais jusque là inconnu de cette famille de matériaux. Ce résultat est remarquable puisqu'il permet une utilisation nouvelle de la famille des isolants de Mott centrosymétriques en tant que matériaux actif dans les mémoires de stockage de données de type RRAM ou MEMRISTORS par exemple.

Les Isolant de Mott constituent une classe de matériaux dont la structure électronique résulte de la présence de fortes répulsions coulombiennes entre électrons. La structure électronique des solides se décrit généralement dans le cadre de la théorie des bandes qui néglige ces répulsions coulombiennes entre électrons situés sur le même site (atome, agrégat d'atomes ou molécule). Cette théorie est appropriée pour les métaux et les semi-conducteurs (ou isolants de bandes), mais ne parvient pas à décrire correctement le cas des Isolants de Mott. Selon cette théorie, la création d'orbitales cristallines dans un solide forme une succession de bandes d'énergies accessibles aux électrons.

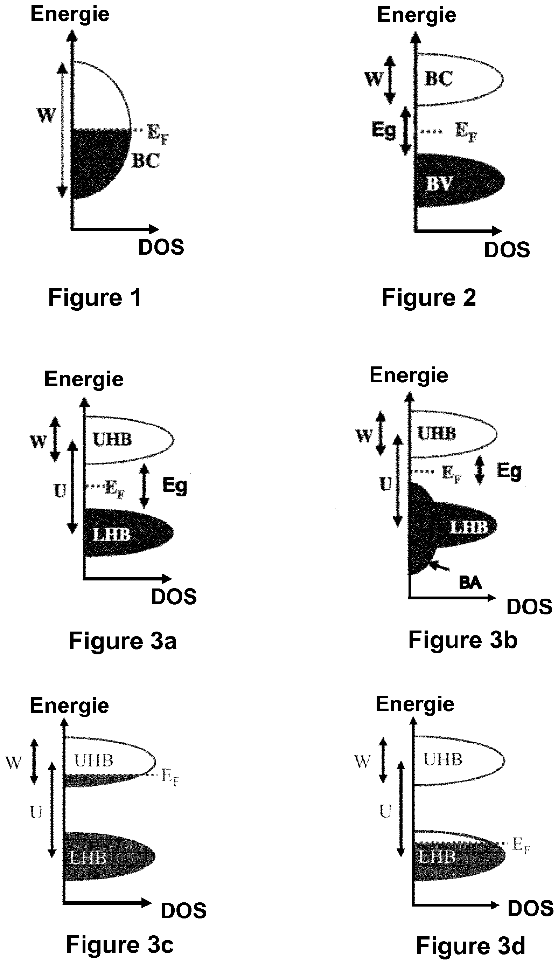

Les **figures 1 et 2** proposent une représentation schématique de la densité des états électroniques ou DOS (pour « Density of States ») pour un métal et un semi-conducteur (ou un isolant de bandes) respectivement. Pour les métaux, la plus haute bande d'énergie occupée est partiellement remplie. Le niveau de Fermi (noté E_{F} et appelé aussi potentiel chimique des électrons), qui correspond dans ce cas au dernier niveau électronique occupé, se place donc au milieu de cette bande d'énergie. La possibilité offerte aux électrons situés au niveau de Fermi de pouvoir gagner de l'énergie, c'est-à-dire d'être accélérés sous l'effet d'un champ électrique confère à ces composés la capacité d'être de bons conducteurs électriques. A l'inverse, les semi-conducteurs (et de manière plus générale les isolants de bandes) possèdent une structure électronique formée de bandes d'énergie complètement remplies ou vides. Dans ces composés, le niveau de Fermi E_{F} se place dans la bande d'énergie interdite (aussi appelé « gap »), de largeur E_{g}, qui sépare le sommet de la dernière bande pleine (appelée généralement Bande de Valence, notée BV sur la figure) du bas de la première bande vide (appelée généralement Bande de Conduction, notée BC). La largeur de la bande de conduction est notée W. Dans le cas des semi-conducteurs, il est bien connu que les électrons situés au niveau de Fermi ne peuvent pas être accélérés par un champ électrique, puisqu'ils ne peuvent pas gagner de l'énergie. Ces composés sont donc de mauvais conducteurs électriques, appelés isolants électriques.

De manière générale, comme illustré sur les **figures 3a et 3b****,** les isolants de Mott se différencient des isolants de bandes dans le sens où ce sont des composés qui, dans le cadre de la théorie des bandes, présentent autour du niveau de Fermi E_{F} une bande de largeur W demi-remplie (un seul électron sur une bande qui est capable d'accueillir deux électrons de spins opposés) ou partiellement remplie. Selon la théorie des bandes, les composés demi-remplis devraient posséder un caractère métallique. Cependant, lorsque l'énergie de répulsion électrostatique entre électrons situés sur le même site (appelée énergie de Hubbard U) est prise en compte, la bande demi-remplie se sépare en une sous-bande occupée LHB (pour « Lower Hubbard Band ») et une sous-bande vide UHB (pour « Upper Hubbard Band »), ce qui conduit à l'ouverture d'une bande interdite de largeur en énergie E_{g} au niveau de Fermi E_{F}. Comme illustré sur les figures 3a et 3b, l'ouverture de cette bande interdite au niveau de Fermi confère donc aux isolants de Mott un comportement isolant électrique. Ceci est bien connu de l'Homme du Métier comme indiqué de façon plus générale dans le document intitulé « Masatoshi Imada et al. Metal-insulator transitions, Reviews of Modern Physics, Vol. 70, No. 4, pages 1039-1263 (1998) ».

Ce concept d'isolant de Mott avec un seul électron situé sur une bande peut se généraliser aux cas des isolants de Mott multibandes possédant un nombre entier d'électrons situés sur plusieurs bandes.

Plus particulièrement, la famille des isolants de Mott (à une ou plusieurs bandes) est constituée de deux sous-classes, d'une part les isolants de Mott-Hubbard (figure 3a) pour lesquels la bande d'énergie interdite (E_{g}) s'ouvre entre les sous-bandes LHB et UHB, et d'autre part les isolants à Transfert de Charge (figure 3b) pour lesquels la bande d'énergie interdite (E_{g}) s'ouvre entre une bande à caractère anionique BA (tel que par exemple Oxygène 2p, Soufre 3p ou Sélénium 4p), dont le sommet est situé à une énergie supérieure au sommet de la sous-bande LHB, et la sous-bande UHB.

Les figures 3c et 3d montrent une représentation schématique de la densité des états électronique des métaux corrélés. Ces matériaux sont parfois appelés, par abus de langage, isolants de Mott. En effet, un isolant de Mott peut être dopé par une modification chimique appropriée afin d'ajouter des électrons dans la sous-bande UHB ou retirer des électrons dans la sous-bande LHB. Dans ce cas, l'isolant de Mott est dit dopé n ou p, respectivement. Pour ces matériaux dopés n ou p, le niveau de Fermi E_{f} se place dans la sous-bande UHB ou la sous-bande LHB, respectivement. Les isolants de Mott dopé n ou p sont donc des métaux qui ne présentent pas de phase isolante électrique, contrairement aux isolants de Mott classiques utilisés dans le cadre de l'invention. L'Homme du Métier comprend donc que ces composés métalliques ne sont pas considérés comme des isolants de Mott au sens de l'invention. Seuls les isolants de Mott (voir figure 3a et 3b) possédant une bande d'énergie interdite E_{g} au niveau de Fermi E_{f}, présentent un caractère isolant électrique. Comme illustré ci-après en relation avec les figures 4, 5, 6a à 6i, 7a à 7e, de tels isolants de Mott (qui possèdent une bande d'énergie interdite E_{g} au niveau de Fermi E_{f}) utilisés selon l'invention offrent l'avantage de pouvoir commuter, par effet d'avalanche électronique, entre deux états de résistance électrique avec de faibles tensions, des temps de commutation relativement faibles par rapport aux mémoires de l'état de la technique, tout en augmentant l'intégration (à savoir la quantité de données logiques stockées par unité de volume).

Les différents travaux de recherche mettant en évidence les propriétés de ces matériaux sont détaillés ci-après. A titre d'exemples illustratifs, il s'agit des travaux réalisés pour les composés répondant aux formules NiS₂₋ₓSeₓ et V₂₋ₓCrₓO₃. Bien entendu, l'invention ne se limite pas à ces seuls composés, mais peut s'appliquer à tout composé appartenant à la famille des isolants de Mott de type centrosymétrique, c'est-à-dire dont la structure cristallographique possède un centre d'inversion. A titre d'exemples, l'invention peut s'appliquer également aux composés suivants : la solution solide κ-(BEDT-TTF)₂Cu[N(CN)₂]BrₓCl₁₋ₓ (0 ≤ x ≤ 1), la série RNiO₃, où R est une terre rare ou un mélange de terre rare, la solution solide V₂₋ₓAlₓO₃.

La **figure 4** illustre un schéma de la structure d'un composant logique de type Métal - Isolant de Mott - Métal intégrant un matériau actif 1 selon l'invention. Le matériau actif 1 est ici un morceau de cristal d'un composé appartenant à la famille des isolants de Mott centrosymétriques ayant une bande d'énergie interdite au niveau de Fermi (tel que par exemple NiS_{1.89}Se_{0.11} ou V_{0,95}Cr_{0,05}O₃) qui a été préalablement synthétisé, puis clivé. Le morceau de cristal 1 présente par exemple les dimensions typiques suivantes : 150 *µ*m de long, 150 *µ*m de large et 40 *µ*m d'épaisseur. Deux électrodes métalliques 2, formées par exemple au moyen d'une laque de carbone, sont collées sur le morceau de cristal 1. Deux fils d'or 6 relient la laque de carbone à une source d'impulsions de tension 3 et une résistance de charge 4 placée en série. Cette résistance de charge permet de limiter le courant circulant à l'intérieur du matériau actif 1 lorsque ce dernier est soumis aux impulsions de tension (ou champ électrique). Les électrodes métalliques 2 sont espacées l'une de l'autre d'environ 40 *µ*m*.* Le choix du matériau constituant les électrodes électriques et le matériau actif isolant de Mott est réalisé de manière à obtenir un travail de sortie, au niveau des interfaces, sensiblement identique, c'est-à-dire avec un niveau de Fermi sensiblement de même niveau énergétique. Ceci permet une commutation aisée et très rapide entre les deux états de résistance électriques, avec de faibles niveaux de tension.

Le schéma de montage électrique expérimental associé est illustré à la **figure 5**. La tension (notée V_{charge}) aux bornes de la résistance de charge (notée R_{charge}) et la tension aux bornes du matériau actif 1 (notée V_{éch.}) sont mesurées à l'aide de sondes différentielles et d'un oscilloscope. La tension de l'impulsion est définie selon la relation Vᵢₘₚ = V_{éch} + V_{charge} et la résistance du matériau actif (notée R_{éch}) est calculée selon la loi d'Ohm: R_{éch} = V_{éch}/I_{éch}, où I_{éch} = V_{charge} / R_{charge}.

Le composant logique consiste en une structure Métal - Isolant de Mott - Métal constituée par un morceau de cristal 1 et de deux points de contact situés de part et d'autre du morceau de cristal 1.

Dans une variante d'application de l'invention, il est possible d'obtenir une structure de type Métal - Isolant de Mott - Métal, par exemple du type Au/ NiS_{1.89}Se_{0.11}/Au, à l'aide d'un procédé de dépôt en couches minces réalisé sur un substrat, par exemple de silicium.

Les **figures 6a et 6b** illustrent graphiquement le phénomène de commutation résistive non-volatile et réversible induite par impulsions de tension obtenu pour le composé NiS₂ à 110K et à 300K respectivement. Les tests ont été réalisés sur une structure de type Métal - Isolant de Mott - Métal intégrant le composé NiS₂ en mode deux points. Des impulsions de tension de + 40V à 110K et + 15V à 300K de durée de quelques microsecondes ont été appliqués au composant logique et la résistance du matériau a été mesurée après chaque impulsion. Une variation non-volatile de la résistance a pu être observée après chaque impulsion.

Les courbes montrent que le composant logique intégrant le composé NiS₂ forme une cellule élémentaire d'information logique contenant au moins deux états de résistance. Plusieurs cycles de commutation résistive ont pu être reproduit dans le temps à 110 K et à 300 K sans effet de fatigue du matériau.

La **figure 6c** représente l'évolution de la résistance du composé NiS₂ en fonction de la température avant (courbe référencée 7) et après (courbe référencée 8) commutation du matériau actif. Ici, l'état du matériau après commutation possède une nature différente de l'état avant commutation. Les dépendances en température de la résistance du matériau dans les deux états sont différentes.

Les **figures 6d à 6h** représentent l'évolution temporelle de la tension V_{éch} (ou champ électrique E_{éch}) et du courant I_{éch} mesurées aux bornes des composés NiS₂, NiS_{1.89}Se_{0.11}, NiS_{1.79}Se_{0.21}, NiS_{1.70}Se_{0.30}, NiS_{1.63}Se_{0.37}, ainsi que les caractéristiques courant-tension correspondantes.

Les tests ont été réalisés sur une structure de type Métal - Isolant de Mott - Métal intégrant les composés NiS₂, NiS_{1.89}Se_{0.11}, NiS_{1.79}Se_{0.21}, NiS_{1.70}Se_{0.30}, NiS_{1.63}Se_{0.37} mis en série avec les résistances de charge suivantes : R_{charge}(NiS₂) = 500 Ω, R_{charge}(NiS_{1.89}Se_{0.11}) = 500 Ω, R_{charge}(NiS_{1.79}Se₀₂₁) = 500 Ω, R_{charge}(NiS_{1.70}S_{e0.30}) = 500 Ω, R_{charge}(NiS_{1.63}Se_{0.37}) = 1.2 kΩ. On observe sur ces courbes que, pour chaque composé, l'état après commutation est défini par une valeur seuil de tension. Plus précisément, on relève que la valeur de champ électrique seuil est égale environ à 7kV/cm pour le composé NiS₂, à 5kV/cm pour le composé NiS_{1.89}Se_{0.11}, à 4kV/cm pour le composé NiS_{1.79}Se_{0.21}, à 3kV/cm pour le composé NiS_{1.70}Se_{0.30}, à 1,7kV/cm pour le composé NiS_{1.63}Se_{0.37}. Autrement dit, la commutation résistive induite par impulsion électrique est reliée à un effet de champ électrique avec apparition d'une valeur seuil de champ électrique au delà de laquelle le matériau commute depuis un premier état de résistance électrique vers un état de résistance électrique inférieur pour former une cellule élémentaire d'information logique.

Les inventeurs ont découvert que la valeur seuil du champ électrique varie en loi de puissance avec l'énergie de bande interdite des composés de Mott comme le montre l'étude de la série de composés NiS₂₋ₓSeₓ. L'allure caractéristique de la courbe I(V), la valeur seuil du champ électrique (de l'ordre de quelques kV/cm) et l'évolution de cette valeur seuil en fonction de l'énergie de bande interdite (« gap ») des composés NiS₂₋ₓSeₓ montrent que la commutation résistive volatile de ces composés est reliée à un claquage diélectrique par effet d'avalanche électronique. Cet effet d'avalanche ou de création de paires électron-trou via une ionisation par impact menant à une multiplication des porteurs, bien connu dans les semi-conducteurs classiques, était jusque là inconnu dans les isolants de Mott. En effet, comme le montre le graphique de la **figure 6i****,** l'évolution de la valeur seuil du champ électrique en fonction de l'énergie de bande interdite pour les semi-conducteurs classiques (tels que GaSb, InAs, InP, GaAs, GaN...) est sensiblement la même que pour les composés de formule NiS₂₋ₓSeₓ.

A noter que le caractère volatile et non-volatile de la transition résistive dépend essentiellement de l'amplitude du champ électrique appliqué sur le matériau actif. Les figures 6d à 6i ci-dessus mettent en exergue le phénomène de transition volatile à partir d'un champ électrique seuil. Pour obtenir une transition résistive non-volatile (comme dans le cas des figures 6a et 6b), des impulsions de tension plus élevées générant un champ électrique supérieur au champ seuil pour le composé considéré doivent être appliquées.

A noter également que les inventeurs ont découvert que le temps de commutation décroît lorsque l'épaisseur de matériau actif décroît.

La **figure 7a** illustre graphiquement le phénomène de commutation résistive non-volatile et réversible induite par impulsions de tension obtenu pour le composé V_{∼1.85}Cr_{∼0.15}O₃ à 293K. Les tests ont été réalisés sur un monocristal du composé V_{∼1.85}Cr_{∼0.15}O₃ selon une géométrie Métal-Isolant de Mott-Métal telle que décrite sur la figure 4. Des impulsions de tension de + 80V et de -50V, d'une durée de quelques dizaines de microsecondes, ont été appliqués alternativement au matériau actif et la résistance de celui-ci a été mesurée après chaque impulsion. Une variation non-volatile de la résistance est observée après chaque impulsion. Comme pour les composés NiS₂₋ₓSeₓ, la courbe montre ici que le composé V_{∼1.85}Cr_{∼0.15}O₃ forme, sous l'effet d'un champ électrique, un composant logique pouvant générer un bit d'information possédant soit un état de haute résistance (considéré comme un « 1 » logique), soit un état de basse résistance (considéré comme un « 0 » logique). Plusieurs cycles de commutation résistive ont pu être reproduits à 293K sans effet de fatigue du matériau.

Dans une variante d'application de l'invention, une structure de type Métal - Isolant de Mott - Métal obtenue à l'aide d'un procédé de dépôt en couches minces permet avantageusement, de par la réduction d'épaisseur du matériau actif, d'abaisser fortement la tension de commutation (par exemple inférieure à 2 V) et la durée des impulsions nécessaire à la commutation (par exemple inférieure à 100 ns).

La **figure 7b** représente l'évolution de la résistance du composé V_{∼1.85}Cr_{∼0.15}O₃ en fonction de la température avant (courbe référencée 10) et après (courbes référencées 11 et 12) commutation du matériau actif. Ici, l'état après commutation du matériau possède une nature différente de l'état avant commutation. La courbe 11 illustre l'état résistif après application d'une première impulsion de tension et la courbe 12 après application d'une seconde impulsion de tension. Les courbes 10, 11 et 12 représentent trois états distincts de résistance, ce qui illustre la possibilité de créer une cellule élémentaire d'information avec au moins trois états logiques, particulièrement intéressante par exemple dans le cadre des MEMRISTORS.

Les **figures 7c et 7d** représentent l'évolution temporelle de la tension V_{éch} (ou champ électrique E_{éch}) et du courant I_{éch} mesurées aux bornes des composés V_{∼1.85}Cr_{∼0.15}O₃ et V_{∼1.94}Cr_{∼0.06}O₃, ainsi que les caractéristiques courant-tension correspondantes. Les tests ont été réalisés sur une structure de type Métal - Isolant de Mott - Métal intégrant les composés mis en série avec une résistance de charge conformément au schéma de la figure 4.

On observe également sur ces courbes que, pour chaque composé, une transition résistive volatile apparaît pour une valeur seuil de champ électrique donné : environ 2.2kV/cm pour le composé V_{∼1.85}Cr_{∼0.15}O₃, et environ 3,8kV/cm pour le composé V_{∼1.94}Cr_{∼0.06}O₃ pour une distance entre électrodes comprise entre 60 et 80µm environ.

Ces valeurs seuil de champ électrique ont été reportées sur le graphique illustrant l'évolution du champ électrique seuil en fonction de l'énergie de bande interdite (voir la **figure 7e****).** On note que le composé V_{∼1.85}Cr_{∼0.15}O₃, dans l'état paramagnétique, possède un gap inférieur à celui de V_{∼1.94}Cr_{∼0.06}O₃, qui est situé dans la phase antiferromagnétique. On remarque en outre que la transition résistive volatile observée dans les composés V₂₋ₓCrₓO₃ présente la même phénoménologie que celle observée pour les composés NiS₂₋ₓSeₓ. En particulier, le champ électrique seuil évolue en fonction de l'énergie de bande interdite selon la loi universelle établie pour les semi-conducteurs classiques et qui a déjà été retrouvée dans le cadre des tests réalisés pour les isolants de Mott répondant à la formule NiS₂₋ₓSeₓ.

Cette découverte établit donc que cette propriété d'avalanche électronique ainsi que ses conséquences sont générales à tous les isolants de Mott centrosymétriques. L'effet du champ électrique sur ces matériaux induit un claquage diélectrique par effet d'avalanche électronique qui a pour conséquence de détruire localement l'état isolant de Mott et de restaurer un état métallique, d'où l'apparition d'une transition résistive.

## Revendications

1. Utilisation d'un matériau (1) appartenant à la famille des isolants de Mott centrosymétriques non dopés n ou p configurés d' une bande d'énergie interdite au niveau de Fermi présentant ainsi un caractère isolant électrique comme matériau actif d'une mémoire de stockage de données à commutation résistive, ledit matériau étant placé entre deux électrodes électriques (2), chaque électrode formant une interface avec ledit matériau et présentant un travail de sortie sensiblement identique à celui dudit matériau au niveau de ladite interface de sorte à former un contact ohmique, et à l'aide desquelles un champ électrique d'une valeur prédéterminée est appliqué pour former, par effet d'avalanche électronique dans le matériau, une cellule élémentaire d'information contenant au moins deux états logiques.

2. Utilisation d'un matériau selon la revendication 1, ledit matériau appartenant à une sous-famille de composés inorganiques.

3. Utilisation d'un matériau selon la revendication 2, dans laquelle la sous-famille de composés inorganiques répond à la formule NiS₂₋ₓSeₓ, avec 0 ≤ x ≤ 1.

4. Utilisation d'un matériau selon la revendication 2, dans laquelle la sous-famille de composés inorganiques répond à la formule V₂₋ₓMₓO₃, avec 0 ≤ x ≤ 1, M comprenant l'un au moins des éléments suivants : Ti, Cr, Fe, Al, ou Ga.

5. Utilisation d'un matériau selon la revendication 1, ledit matériau appartenant à une sous-famille de composés organiques.

6. Utilisation d'un matériau selon l'une quelconque des revendications 1 à 5, dans laquelle la composition chimique du matériau utilisé est choisie de façon à fixer une valeur seuil de champ électrique au delà de laquelle le matériau commute depuis un premier état de résistance électrique vers un ou plusieurs états de résistance électrique différents pour former une cellule élémentaire d'information contenant au moins deux états logiques.

## Patentansprüche

1. Verwendung eines Materials (1), welches zur Familie der zentrosymmetrischen, nicht n- oder p-dotierten Mott-Isolatoren, welche mit einer Energiebandlücke auf Fermi-Niveau ausgestaltet sind, wodurch sie eine elektrisch isolierende Eigenschaft aufweisen, gehört, als ein aktives Material eines Speichers zur Datenspeicherung mit Widerstandsumschaltung, wobei das Material zwischen zwei elektrischen Elektroden (2) platziert ist, von denen jede Elektrode eine Schnittstelle mit dem Material bildet und eine Austrittsarbeit, welche im Wesentlichen gleich derjenigen des Materials ist, an der Schnittstelle aufweist, so dass ein ohmscher Kontakt ausgebildet wird, und mittels deren ein elektrisches Feld von einem vorbestimmten Wert angelegt wird, um mittels des Elektronenlawineneffekts in dem Material eine Informationselementarzelle, welche mindestens zwei logische Zustände aufweist, zu bilden.

2. Verwendung eines Materials gemäß dem Anspruch 1, wobei das Material zu einer Unterfamilie von anorganischen Verbindungen gehört.

3. Verwendung eines Materials gemäß dem Anspruch 2, wobei die Unterfamilie von anorganischen Verbindungen die Formel NiS₂₋ₓSeₓ mit 0 ≤ x ≤ 1 erfüllt.

4. Verwendung eines Materials gemäß dem Anspruch 2, wobei die Unterfamilie von anorganischen Verbindungen die Formel V₂₋ₓMₓO₃ mit 0 ≤ x ≤ 1 erfüllt, wobei M zumindest eines der folgenden Elemente umfasst: Ti, Cr, Fe, Al oder Ga.

5. Verwendung eines Materials gemäß dem Anspruch 1, wobei das Material zu einer Unterfamilie von organischen Verbindungen gehört.

6. Verwendung eines Materials gemäß irgendeinem der Ansprüche 1 bis 5, wobei die chemische Zusammensetzung des verwendeten Materials derart gewählt ist, dass ein Grenzwert des elektrischen Felds festgelegt ist, oberhalb dessen das Material von einem ersten Zustand elektrischen Widerstands zu einem oder mehrere unterschiedliche Zustände elektrischen Widerstands umschaltet, um eine Informationselementarzelle, welche mindestens zwei logische Zustände aufweist, zu bilden.

## Claims

1. Use of a material (1) belonging to the family of the centrosymmetric Mott insulators which are not n- or p-doped and are configured with an energy band gap at the Fermi level, thus having an electrically insulating nature, as active material of a resistive switching data storage memory, said material being placed between two electrical electrodes (2), each electrode forming an interface with said material and having a work function which is substantially identical to that of said material at the level of said interface so as to form an ohmic contact, and by means of which an electric field of a predetermined value is applied in order to form, by an electron avalanche effect in the material, an elementary information cell containing at least two logic states.

2. Use of a material according to claim 1, said material belonging to a sub-family of inorganic compounds.

3. Use of a material according to claim 2, wherein the sub-family of inorganic compounds complies with the formula NiS₂₋ₓSeₓ, where 0 ≤ x ≤ 1.

4. Use of a material according to claim 2, wherein the sub-family of inorganic compounds complies with the formula V₂₋ₓMₓO₃, where 0 ≤ x ≤ 1, M comprising at least one of the following elements: Ti, Cr, Fe, Al or Ga.

5. Use of a material according to claim 1, said material belonging to a sub-family of organic compounds.

6. Use of a material according to any one of claims 1 to 5, wherein the chemical composition of the material used is chosen so as to fix an electric field threshold value beyond which the material switches from a first electrical resistance state to one or more different electrical resistance states in order to form an elementary information cell containing at least two logic states.
